# EUROPEAN PATENT APPLICATION

(11) **EP 1 055 745 A1**
(43) Date of publication of application: **29.11.2000**
(21) Application number: 99115989.8
(22) Date of filing: 13.08.1999
(51) Int. Cl.: C23C 14/48

(54) **Method and apparatus for surface modification**

(30) Priority: 27.05.1999 JP 14890599
(71) Applicant: SONY CORPORATION, Tokyo (JP)
(72) Inventor: Tonosaki, Minehiro, Shinagawa-ku, Tokyo (JP); Kobayashi, Masato, Shinagawa-ku, Tokyo (JP); Ueda, Mitsunori, Shinagawa-ku, Tokyo (JP); Okita, Hiroyuki, Shinagawa-ku, Tokyo (JP)
(74) Representative: MÜLLER & HOFFMANN Patentanwälte

(57) **Abstract**

A surface modification is performed by generating plasma containing required ions to implant into a work which must be processed. The surface modification is enabled to be employed even if the object (2) which must be processed is an insulator. An apparatus (1) for surface modification for modifying the surface of an insulator (2) by implanting ions into the insulator incorporates a plasma generating unit (10) for generating plasma containing ions which are implanted into the insulator; and a voltage applying unit (8) for applying pulse-shape voltage to the insulator. A plasma generator generates plasma containing ions which are implanted into the insulator. In the plasma, the voltage applying unit applies pulse-shape voltage containing positive pulse-shape voltage and negative pulse-shape voltage to the insulator. Thus, ions contained in the plasma are implanted into the insulator.

## Description

### Background of the Invention

### Field of the Invention

The present invention relates to a method and an apparatus for surface modification for modifying the surface of an insulator by implanting ions into the insulator.

### Description of the Related Art

A method has been employed with which a material is subjected to surface modification to modify a variety of characteristics including hardness, elasto-plasticity, electric conductivity, lubricity, durability, moisture resistance, corrosion resistance, wettability and gas permeability. As for the foregoing method, a method has been known with which ions are implanted into the work which must be processed so as to modify the surface of the work.

As a method for implanting ions into the work which must be processed, a method (hereinafter called an "ion-beam implantation method") has been known with which the work is directly irradiated with ion beams so that ions are implanted into the work which must be processed.

The ion-beam implantation method, however, suffers from a problem in that ions cannot uniformly be implanted into the work which must be processed when the work has a three-dimensional structure.

### Object and Summary of the Invention

A method has been devised which is capable of overcoming the above-mentioned problem and uniformly implanting ions even if the work which must be processed has a three-dimensional structure. The method (hereinafter called a "plasma implantation method") has the steps of generating plasma containing ions which must be implanted; and accelerating ions contained in the plasma by using a substrate bias so that ions are implanted into the work which must be processed.

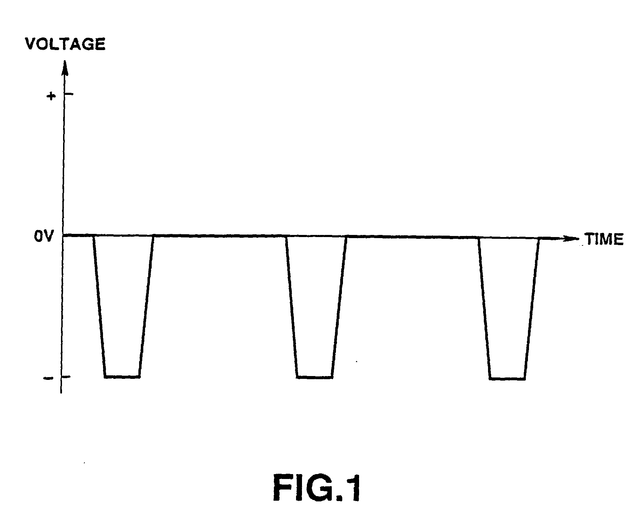

The plasma implantation method is performed such that the work which must be processed is placed in the plasma containing ions which must be implanted. Then, a negative pulse bias voltage as shown in Fig. 1 is applied to the work which must be processed. When the negative voltage has been applied to the work which must be processed, ions in the plasma are implanted into the work.

The foregoing plasma implantation method is performed such that the plasma containing ions which must be implanted is generated around the work which must be processed. Thus, if the work which must be processed has a three-dimensional structure, ions can uniformly be implanted into the surface of the work.

The application of the plasma implantation method, however, is limited to only a case in which the work which must be processed is a conductor, such as metal. The reason for this lies in that electric charges are quickly accumulated in the work which must be processed if implantation of ions using the plasma implantation method is performed when the work which must be processed is an insulator. Thus, a so-called charge-up state is realized. Hence it follows that ions cannot be implanted effectively into the work which must be processed.

In view of the foregoing, an object of the present invention is to provide a method and an apparatus for surface modification by implanting ions by using a plasma implantation method if the work which must be subjected to the surface modification is an insulator.

According to one aspect of the present invention, it provides a surface modification apparatus for implanting ions into an insulator, comprising: means generating plasma including said ions to be implanted into said insulator; means applying voltage pulses to said insulator; means implanting ions into said insulator in said plasma atmosphere by applying positive and/or negative pulse-shape voltage to said insulator.

According to another aspect of the present invention, it provides a method for surface modification of an insulator by electron beam irradiated with; the improvement: applying pulse-shape voltage to the insulator while the insulator is irradiated with electron beam.

The method and apparatus for surface modification according to the present invention are structured such that the bias voltage which is applied to the insulator is the pulse-shape voltage containing positive pulse voltage and negative pulse voltage. Therefore, undesirable accumulation of electric charges in the insulator which must be substrate to the surface modification can be prevented during the ion implantation process. That is, if electric charges are accumulated in the insulator which must be subjected to the surface modification owing to the application of the negative pulse-shape voltage, the electric charges can immediately be neutralized by the positive pulse-shape voltage. Hence it follows that the so-called charge-up state can be prevented. As a result, ions can continuously be implanted into the insulator which must be subjected to the surface modification.

According to the present invention, if the work which must be subjected to the surface modification is an insulator, the surface modification can be performed by implanting ions by the plasma implantation method. Therefore, if the work which must be subjected to the surface modification is, for example, an insulator having a three-dimensional structure, ions can uniformly be implanted into the surface of the work which must be processed so as to modify the surface of the work.

According to the present invention, even plastic which is an insulator can be subjected to the surface modification by implanting ions. That is, the present invention is able to subject plastic to the surface modification by implanting ions so as to modify hardness, elasto-plasticity, electric conductivity, lubricity, durability, moisture resistance, corrosion resistance, wettability and gas permeability. Therefore, according to the present invention, a multiplicity of elements which have been made of metal or glass can be made of the low-cost plastic. Hence it follows that a significant industrial advantage can be realized.

### Brief description of the drawing

Fig. 1 is a graph showing the waveform of a pulse bias voltage which is applied to a work which must be processed by a conventional plasma implantation method;
Fig. 2 is a diagram showing an example of the structure of an apparatus for surface modification according to the present invention;
Fig. 3 is a graph showing an implantation profile realized when ions have been implanted by the ion beam implantation method;
Fig. 4 is a graph showing an implantation profile realized when ions have been implanted by a plasma implantation method according to the present invention;
Fig. 5 is a graph showing a waveform of a pulse-shape voltage which is applied to a work which is subjected to surface modification according to the present invention;
Fig. 6 is a graph showing another waveform of a pulse-shape voltage which is applied to a work which is subjected to surface modification according to the present invention;
Fig. 7 is a graph showing another waveform of a pulse-shape voltage which is applied to a work which is subjected to surface modification according to the present invention;
Fig. 8 is a graph showing another waveform of a pulse-shape voltage which is applied to a work which is subjected to surface modification according to the present invention;
Fig. 9 is a graph showing another waveform of a pulse-shape voltage which is applied to a work which is subjected to surface modification according to the present invention;
Fig. 10 is a graph showing another waveform of a pulse-shape voltage which is applied to a work which is subjected to surface modification according to the present invention;
Fig. 11 is a graph showing another waveform of a pulse-shape voltage which is applied to a work which is subjected to surface modification according to the present invention;
Fig. 12 is a graph showing another waveform of a pulse-shape voltage which is applied to a work which is subjected to surface modification according to the present invention;
Fig. 13 is a graph showing a first example of pulse-shape voltage applied to a plastic substrate according to a first embodiment;
Fig. 14 is a graph showing a second example of pulse-shape voltage applied to a plastic substrate according to a first embodiment;
Fig. 15 is a graph showing results of depression hardness tests of a plastic substrate subjected to the surface modification by implanting ions according to the first embodiment such that results of measurement are shown which were performed by implanting ions by applying the pulse-shape voltage shown in Fig. 13;
Fig. 16 is a graph showing results of depression hardness tests of a plastic substrate subjected to the surface modification by implanting ions according to the first embodiment such that results of measurement are shown which have been performed by implanting ions by applying the pulse-shape voltage shown in Fig. 14;
Fig. 17 is a graph showing results of measurement of infrared spectral characteristics before and after a plastic substrate coated with oil based ink has been subjected to the surface modification by implanting ions according to a second embodiment; and
Fig. 18 is a diagram showing a rotative drum which is subjected to the surface modification according to a third embodiment.

### Detailed description of the preferred embodiment

An embodiment of the present invention will now be described with reference to the drawings.

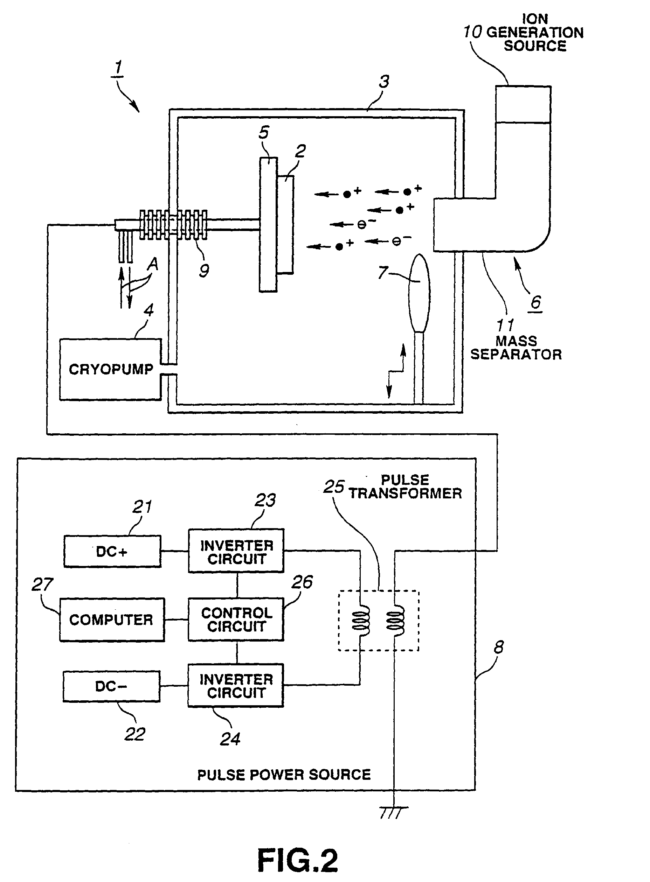

An example of the structure of an apparatus for surface modification according to the present invention is shown in Fig. 2. The apparatus 1 for surface modification according to the present invention is an apparatus for modifying the surface of a work 2 which must be processed by implanting ions into the work 2 made of an insulator by a plasma implantation method.

The material of the work 2 which must be subjected to the surface modification by implanting ions is exemplified by amorphous polyolefine (APO), polycarbonate (PC), polmethylmethacrylate (PMMA), polyethylene terephthalate (PET), acrylic resin, polyimide resin, carbon and glass. The ion source which must be implanted into the work 2 are exemplified by C, N, Ar, W, Ta, Cr, Mo, Co, Pt, Ni, Fe, Ti, Mn, Cu and Sm.

The apparatus 1 for surface modification incorporates a vacuum chamber 3, a cryopump 4 for exhausting the inside portion of the vacuum chamber 3, a holder 5 for supporting the work 2 in the vacuum chamber 3, an ion generator 6 for supplying ions which must be implanted into the work 2, a shutter 7 for performing switching between supply of ions and inhibition of the supply and a pulse power source 8 for applying pulse-shape voltage including positive pulse-shape voltage and negative pulse-shape voltage to the work 2 which must be processed.

The vacuum chamber 3 is a chamber, the inside portion of which is exhausted so as to realize a high vacuum state. In the apparatus 1 for surface modification, plasma containing ions which must be implanted into the work 2 is generated in the vacuum chamber 3. Thus, the ions contained in the plasma are implanted into the work 2.

The cryopump 4 is a vacuum pump for exhausting the inside portion of the vacuum chamber 3 to realize the high vacuum state. The apparatus 1 for surface modification is structured such that the cryopump 4 exhausts the inside portion of the vacuum chamber 3. Thus, high vacuum is realized before ions are implanted into the vacuum chamber 3, that is, the background degree of vacuum, is made to be, for example, about 10⁻⁷ Torr. The degree of vacuum realized when the inside portion of the vacuum chamber 3 has been exhausted by the cryopump 4 to implanted ions into the vacuum chamber 3 so as to generate plasma, that is, the degree of vacuum is, for example, 10⁻⁵ Torr while ions are being implanted,.

The holder 5 supports the work 2. An insulating support member 9 joined to the vacuum chamber 3 secures the holder 5 to the inside portion of the vacuum chamber 3. When the work 2 made of the insulator is subjected to the surface modification, the work 2 is secured to the holder 5.

The holder 5 includes a pipe for introducing cooling water. Cooling water is allowed to flow through the pipe so that the work 2 secured to the holder 5 is cooled. The pipe for introducing cooling water included in the holder 5 is extended to the outside portion of the vacuum chamber 3 through the support member 9. As indicated with an arrow A shown in the drawing, cooling water can be supplied through the pipe for introducing cooling water included in the holder 5 through the pipe for introducing cooling water extended to the outside portion of the vacuum chamber 3.

When ions are implanted by the plasma implantation method, the temperature of the work 2 is raised as the ions are implanted. When the work 2 is made of a material, such as plastic, which must avoid a process which is performed at high temperatures, excessive rise in the temperature of the work 2 caused from implantation of ions raises a problem.

However, the apparatus 1 for surface modification incorporating the holder 5 having the water-cooling function is able to control the temperature of the work 2 while the work 2 is subjected to the surface modification by implanting ions. Therefore, if the work 2 is made of a material, such as plastic, which must avoid a process which is performed at high temperatures, rise in the temperature of the work 2 can be prevented to implant ions into the work 2.

The ion generator 6 is a plasma generating means for supplying ions which must be implanted into the work 2 so as to generate plasma containing ions which must be implanted into the work 2. The ion generator 6 incorporates an ion generation source 10 for generating ions which must be implanted into the work 2 and a mass separator 11 for extracting only ions with unit charge among particles generated by the ion generation source 10.

The ion generation source 10 may be a Kauffmann ion source, a magnetron sputter source or a cathodic arc source. Each of the Kauffmann ion source and a magnetron sputter source is structured such that an operation gas serving as the ion source is implanted so that ions are generated from the operation gas. On the other hand, the cathodic arc source does not use the operation gas when it generates ions. Specifically, the cathodic arc source uses a cathode made of a material which serves as the ion source to cause arc discharge to occur. The arc discharge causes the cathode to be evaporated so that ionized particles are taken. Since the cathodic arc source does not use the operation gas to generate ions, an advantage can be realized in that ions can be generated while a high vacuum state is being maintained.

When the cathodic arc source is employed as the ion generation source 10, there sometimes arises a problem of occurrence of a droplet. To overcome the problem of occurrence of a droplet, a portion of cathodic arc sources employs an electromagnetic filter for removing the droplet. The cathodic arc source of the foregoing type is called filtered cathodic arc source. The apparatus 1 for surface modification may employ the field cathodic arc source as the ion generation source 10.

The ion generation source 10 generates neutral particles and macroparticles having a large mass as well as required ions. A occurrence that particles except for the required ions are moved to the work 2 must be prevented. Therefore, the ion generator 6 incorporates the mass separator 11 for implanting only required ions among the particles generated by the ion generation source 10 into the vacuum chamber 3.

The mass separator 11 has a passage bent by, for example, about 45°. Moreover, magnets are disposed along the passage. Magnetic fields generated by the magnets lead the required ions into the vacuum chamber 3 along the bent passage. On the other hand, the neutral particles and the macroparticles having a large mass cannot easily be lead. Therefore, the foregoing particles cannot pass through the bent passage. Therefore, the foregoing particles are interrupted.

When the mass separator 11 is disposed between the ion generation source 10 and the vacuum chamber 3, the neutral particles and the macroparticles having a large mass can be interrupted. That is, only required ions can be implanted into the vacuum chamber 3. As a result, influences of the neutral particles and macroparticles each having a large mass can be eliminated. Thus, the quality of the result of the surface modification can be improved.

The shutter 7 is disposed adjacent to an ion emitting opening of the ion generator 6 to perform switching between supply of ions and interruption of the supply. When the shutter 7 is opened, ions are supplied from the mass separator 11. When the shutter 7 is closed, supply of ions from the ion generator 6 is interrupted.

The pulse power source 8 is a voltage applying means for applying pulse-shape voltage including positive pulse-shape voltage and negative pulse-shape voltage to the work 2 supported by the holder 5. That is, when ions are lead onto the work 2, the pulse power source 8 applies the pulse-shape voltage serving as bias voltage to the work 2. When the negative pulse-shape voltage is applied to the work 2, ions in the plasma are implanted into the work 2. Thus, ions are implanted into the work 2.

The pulse power source 8 incorporate a first power source 21 serving as a positive DC voltage source, a second power source 22 serving as a negative DC voltage source, a first inverter circuit 23 for converting the DC voltage supplied from the first power source 21 into the pulse-shape voltage, a second inverter circuit 24 for converting the DC voltage supplied from the second power source 22 into the pulse-shape voltage, a pulse transformer 25 for raising the levels of the pulse-shape voltages applied from the first and second inverter circuits 23 and 24, a control circuit 26 for controlling the first and second inverter circuits 23 and 24 and a computer 27 for controlling the operation of the control circuit 26.

The first inverter circuit 23 of the pulse power source 8 converts the positive DC voltage supplied from the first power source 21 into the pulse-shape voltage. The second inverter circuit 24 converts the negative DC voltage supplied from the second power source 22 into the pulse-shape voltage.

Outputs from the first and second inverter circuits 23 and 24 are controlled by the control circuit 26. In the pulse power source 8, the first inverter circuit 23 for outputting the positive pulse-shape voltage and the second inverter circuit 24 for outputting the negative pulse-shape voltage are operated in parallel. Since the first and second inverter circuits 23 and 24 are controlled by the control circuit 26, the pulse peak value, the first transition time of the pulse, the intervals between pulses and the pulse width of each of the positive and negative pulse-shape voltages output from the first and second inverter circuits 23 and 24 are independently be changed.

Specifically, the control circuit 26 switches the output from the first inverter circuit 23 and that from the second inverter circuit 24 and controls the outputs from the same in such a manner that the positive pulse-shape voltage output from the first inverter circuit 23 and the negative pulse-shape voltage output from the second inverter circuit 24 are alternately output. The pulse-shape voltages controlled by the control circuit 26 and output from the first and second inverter circuits 23 and 24 are supplied to a primary coil of the pulse transformer 25.

The level of the pulse-shape voltage supplied to the pulse transformer 25 is raised by the pulse transformer 25. A terminal connected to the secondary coil of the pulse transformer 25 is allowed to pass through the support member 9 for supporting the holder 5 so as to be disposed on the surface of the holder 5 for supporting the work which must be processed. When the work 2 has been joined to the holder 5, the pulse-shape voltage having the level raised by the pulse transformer 25 is, therefore, applied to the work 2 which must be processed.

The pulse-shape voltage which is applied to the work 2 contains the pulse obtained by raising the level of the positive pulse-shape voltage output from the first inverter circuit 23 and the pulse obtained by raising the level of the negative pulse-shape voltage output from the second inverter circuit 24. That is, the work 2 is applied with the pulse-shape voltage containing the positive pulse voltage and the negative pulse voltage.

As described above, the work 2 is applied with the voltage which is the pulse-shape voltage containing the positive pulse voltage and the negative pulse voltage. Hence it follows that undesirable accumulation of electric charges in the work 2 can be prevented while ions are implanted into the work 2. If electric charges are accumulated in the work 2 owing to the application of the negative pulse voltage, the foregoing electric charges can immediately be neutralized by the positive pulse voltage. If electric charges are accumulated in the work 2 owing to the application of the positive pulse voltage, the foregoing electric charges can immediately be neutralized by the negative pulse voltage. Therefore, the so-called charge-up state can be prevented. Thus, continuous implantation into the work 2 is permitted.

Note that the pulse power source 8 is structured such that the peak value of the pulse voltage applied to the work 2, the pulse first transition time, the intervals between pulses, the pulse width or the order of the positive and negative pulses can arbitrarily be controlled by issuing an instruction to the computer 27. That is, when the pulse power source 8 is operated, the waveform of the pulse-shape voltage which must be applied to the work 2 which must be processed is input to the computer 27. In accordance with the input instruction, the computer 27 controls the operation of the control circuit 26. In accordance with the instruction issued from the computer 27, the control circuit 26 controls the outputs from the first and second inverter circuits 23 and 24 in such a manner that the pulse-shape voltage having a required waveform is applied to the work 2 which must be processed.

Specifically, each peak value of the positive and negative pulse-shape voltages which are applied to the work 2 can independently be changed from about 0 V to about 40 kV. Moreover, the pulse width can be changed in a range from several µsec to several seconds. The intervals between the pulses can be changed from several seconds to tens of µsec. Also the order of the positive and negative pulses can be controlled by the computer 27 connected to the control circuit 26.

It is preferable that the first and second inverter circuits 23 and 24 of pulse power source 8 are constituted by circuits incorporating semiconductor devices. The inverter circuit incorporating the semiconductor device is a low-cost circuit. Therefore, use of the circuit incorporating the semiconductor devices to serve as the first and second inverter circuits 23 and 24 which is included in the pulse power source 8 enables the pulse power source 8 to be constituted at a low cost. Since the size of the circuit incorporating the semiconductor devices can easily be reduced, the size of pulse power source 8 can be reduced.

When the first and second inverter circuits 23 and 24 are constituted by the circuits incorporating the semiconductor devices, a high output voltage cannot easily be obtained from each of the first and second inverter circuits 23 and 24. In the foregoing case, the levels of the outputs from the first and second inverter circuits 23 and 24 must be raised by the pulse transformer 25 as the foregoing pulse power source 8.

When the circuit incorporating the semiconductor devices to serve as the first and second inverter circuits 23 and 24 is employed, the pulse peak value of the pulse-shape voltage output from the first and second inverter circuits 23 and 24 is about several hundreds of V to about several kilos of V. The levels of the pulse-shape voltage is raised by the pulse transformer 25 so that the pulse-shape voltage having a pulse peak value of tens of kV is generated. The pulse voltage having the level raised by the pulse transformer 25 is applied to the work 2 which must be processed.

The first and second inverter circuits 23 and 24 may be constituted by circuits incorporating vacuum tubes. The inverter circuits incorporating the vacuum tubes enables high output voltages to be obtained. When the circuits incorporating the vacuum tubes are employed as the first and second inverter circuits 23 and 24, the pulse-shape voltages output from the first and second inverter circuits 23 and 24 may directly be applied to the work 2 which must be processed such that the pulse transformer 25 is bypassed.

When the surface modification apparatus 1 structured as described above is used to subject the work 2 made of the insulator to surface modification by implanting ions, the work 2 which must be processed is secured to the holder 5 disposed in the vacuum chamber. Then, the inside portion of the vacuum chamber is exhausted by the cryopump 4 so that a high vacuum state is realized. The degree of vacuum in the vacuum chamber 3, that is, the degree of vacuum (the background degree of vacuum) realized before ion implantation into the vacuum chamber 3 is made to be, for example, about 10⁻⁷ Torr.

If the work 2 is made of a material, such as plastic, which must avoid a process which is performed at high temperatures, cooling water is allowed to flow through the pipe for introducing cooling water included in the holder 5. Thus, excessive rise in the temperature of the work 2 is prevented.

Then, ion generator 6 generates ions which must be lead onto the work 2. Thus, the ions are implanted into the vacuum chamber 3. As a result, plasma containing the ions which must be implanted into the work 2 is generated in the vacuum chamber 3. The degree of vacuum in the vacuum chamber 3 is, for example, about 10⁻⁵ Torr while ions are implanted,.

In a state in which the work 2 is placed in the plasma containing the ions which must be implanted, the pulse-shape voltage containing the positive pulse-shape voltage and the negative pulse-shape voltage is generated by the pulse power source 8. The foregoing pulse-shape voltage is, as the bias voltage, applied to the work 2. As a result, ions are implanted into the work 2 so that the ions are implanted into the work 2.

Specifically, when the negative pulse-shape voltage has been applied to the work 2 which must be processed, positive ions contained in the plasma are implanted into the work 2. Thus, the positive ions are implanted into the work 2. An amount of ions which are implanted into the work 2, the depth of implantation and the implantation profile depend on the pulse peak value, the first transition time of the pulse, the intervals of the pulses and the pulse width of the negative pulse-shape voltage which is applied to the work 2. Therefore, the waveform of the pulse-shape voltage which is applied to the work 2 is controlled so that the amount of ions which are implanted into the work 2, the depth of the implantation and the implantation profile are controlled. Note that the "implantation profile" is the relationship between the depth from the surface of the work 2 and the density of ions which are implanted into the work 2.

When positive ions are implanted into the work 2 as described above, electric charges are accumulated in the work 2 which must be processed. Therefore, continuation of application of the negative voltage to the work 2 results in a fact that implantation of ions into the work 2 made of the insulator cannot be continued. Therefore, the apparatus 1 for surface modification is structured such that the bias voltage which is applied to the work 2 is the pulse voltage including the positive pulse-shape voltage and the negative pulse-shape voltage. Thus, electric charges accumulated in the work 2 is neutralized by the positive pulse-shape voltage.

Specifically, when the positive pulse-shape voltage is applied to the work 2, electrons are implanted into the work 2. The electrons neutralize the electric charges accumulated in the work 2. Thus, the electric charges accumulated in the work 2 are neutralized. When the negative pulse-shape voltage is applied, positive ions, therefore, are implanted into the work 2. Thus, ions can be implanted into the work 2.

As described above, the bias voltage which is applied to the work 2 is made to be the pulse-shape voltage including the positive pulse-shape voltage and the negative pulse-shape voltage. Therefore, the charge-up state can be prevented even if the work 2 is an insulator. Hence it follows that ions can be implanted into the work 2.

Since the implantation of ions is performed by the plasma implantation method with which ions contained in the plasma are implanted into the work 2, an effect different from the ion-beam implantation method can be obtained in that ions can uniformly be implanted into the surface of the work 2 even if the work 2 has a three-dimensional structure.

The work 2 which must be subjected to the surface modification by implanting ions is exemplified by a rotative drum for use to record and/or play a magnetic tape, a substrate for supporting a recording layer of a recording medium, a recording medium having a substrate on which a recording layer is formed, a recording medium having a substrate on which a recording layer is formed and a protective film formed on the recording layer, a panel substrate of a liquid crystal panel for permitting liquid crystal to be enclosed, printed matter having an insulator on which printing is performed and a variety of micromachines each of which is made of an insulating material, such as plastic.

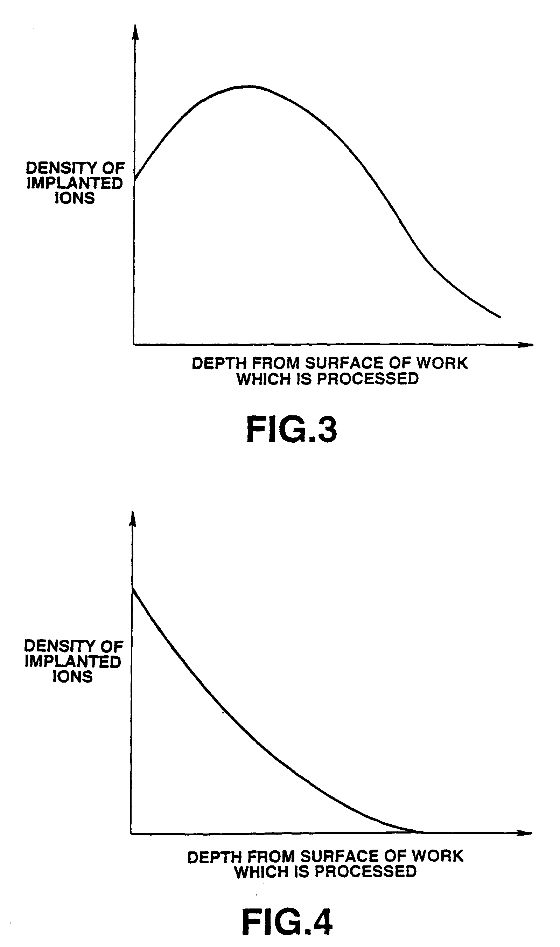

When the ion beam implantation method is performed, an ion beam having predetermined energy is accelerated and implanted into the work which must be processed. The implantation profile (the relationship between the depth from the surface of the work and the density of ions implanted into the work) is formed into a Gaussian distribution having a peak at a certain depth from the surface, as shown in Fig. 3.

On the other hand, when ions are implanted by the apparatus 1 for surface modification which employs the plasma implantation method, the pulse-shape voltage which is applied to the work 2 is controlled. Thus, the amount of ions which must be implanted into the work 2, the depth of the implantation and the implantation profile can be controlled. Therefore, for example, the implantation profile can be formed such that the profile has a peak adjacent to the surface, as shown in Fig. 4.

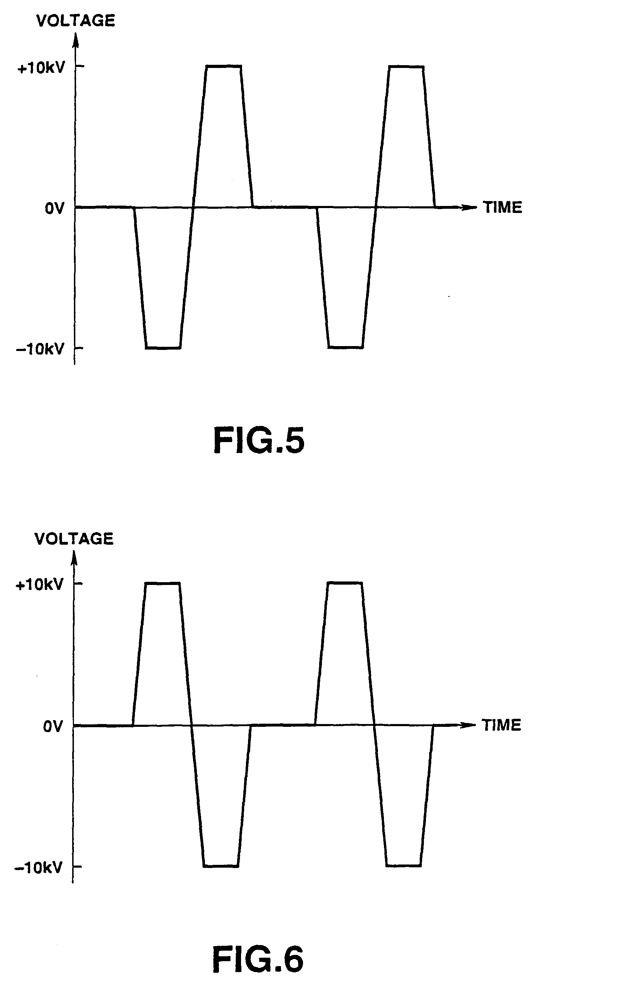

Then, examples (see Figs. 5 to 12) of the pulse-shape voltage which is applied to the work 2 when ions are implanted by the apparatus 1 for surface modification will now be described.

In the example shown in Fig. 5, the negative pulse-shape voltage is first applied. Immediately after this, the positive pulse-shape voltage having substantially the same absolute value of the pulse peak is applied. Moreover, a period in which no voltage is applied is provided after the positive pulse-shape voltage has been applied. A pulse train having the foregoing waveform is repeatedly applied to the work 2 which must be processed.

When the waveform of the pulse-shape voltage is made to be as shown in Fig. 5, positive ions are accelerated and implanted into the work 2 when the negative pulse-shape voltage has been applied. Since the positive ions are implanted into the work 2, electric charges are accumulated in the work 2. When the positive pulse-shape voltage is applied, electrons are implanted into the work 2. As a result, the electric charges accumulated in the work 2 can be neutralized.

The pulse-shape voltage having the waveform as shown in Fig. 5 is, as the bias voltage, applied to the work 2. Thus, even if the work 2 is an insulator, the charge-up state can be prevented. Thus, implantation of ions into the work 2 can be continued.

Fig. 6 shows an example in which the order of positive and negative voltages are inverted from the example shown in Fig. 5. In the example shown in Fig. 6, the positive pulse-shape voltage is initially applied. Immediately after this, the negative pulse-shape voltage having substantially the same absolute value of the pulse peak is applied. Then, a period in which no voltage is applied is provided after the application of the negative pulse-shape voltage. The foregoing pulse train is repeatedly applied to the work 2.

Also in the case in which the pulse-shape voltage has the waveform as shown in Fig. 6, positive ions are accelerated and implanted into the work 2 similarly to the example shown in Fig. 5 when the negative pulse-shape voltage has been applied. As a result, ions are implanted into the work 2. Since the positive ions are implanted into the work 2, electric charges are accumulated in the work 2. When the positive pulse-shape voltage has been applied, electrons are implanted into the work 2. Thus, the electric charges accumulated in the work 2 can be neutralized.

Therefore, application of the pulse-shape voltage having the waveform as shown in Fig. 6 to the work 2 as the bias voltage prevents realization of the charge-up state even if the work 2 is an insulator similarly to the example shown in Fig. 5. Thus, implantation of ions into the work 2 can be continued.

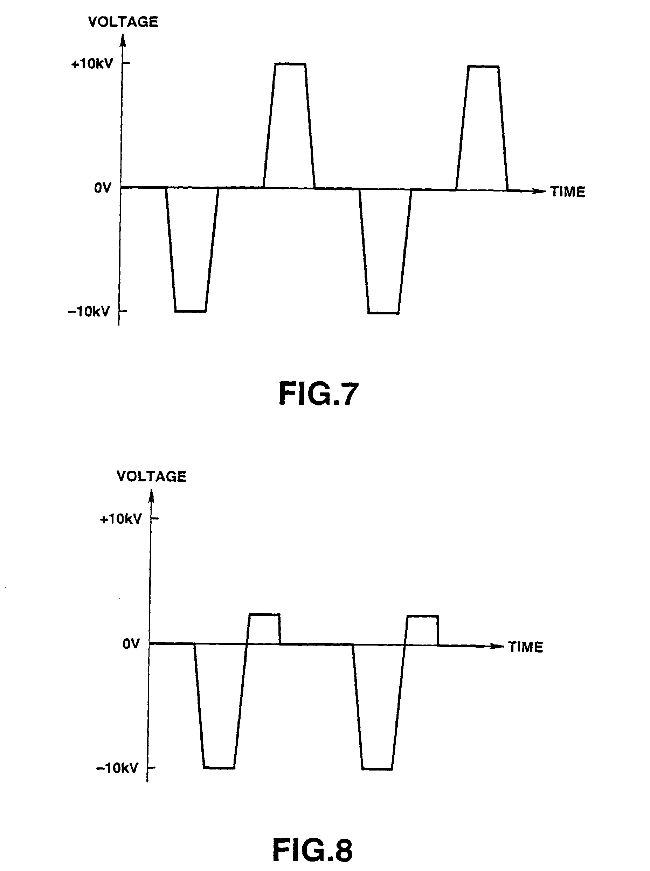

In an example shown in Fig. 7, the negative pulse-shape voltage is first applied. Then, a period in which no voltage is applied is provided. Then, a positive pulse-shape voltage having substantially the same absolute value of the pulse peak as that of the negative pulse-shape voltage is applied. Then, a period in which no voltage is applied is provided. The foregoing pulse train is repeatedly applied to the work 2.

Also in the case where the pulse-shape voltage has the waveform as shown in Fig. 7, positive ions are accelerated and implanted into the work 2 when the negative pulse-shape voltage has been applied similarly to the examples shown in Figs. 5 and 6. Thus, implantation of ions into the work 2 is performed. At this time, positive ions are implanted into the work 2. Thus, positive charges are accumulated in the work 2. On the other hand, application of the positive pulse-shape voltage causes electrons to be implanted into the work 2. As a result, the positive charges accumulated in the work 2 can be neutralized.

Therefore, application of the pulse-shape voltage having the waveform as shown in Fig. 7 to the work 2 as the bias voltage enables implantation of ions into the work 2 to be continued without occurrence of the charge-up state even if the work 2 is an insulator similarly to the examples shown in Figs. 5 and 6.

Moreover, the example shown in Fig. 7 is structured such that the period in which no voltage is applied after application of the negative pulse-shape voltage is provided. Thus, the positive pulse-shape voltage is applied after a lapse of a certainly long period of time. In the foregoing case in which the period in which no voltage is applied after the negative pulse-shape voltage has been applied, the electric charges accumulated in the work 2 are removed in a certain quantity during the foregoing period. Therefore, neutralization of the electric charges owing to the application of the positive pulse-shape voltage can easily be performed.

In an example shown in Fig. 8, the negative pulse-shape voltage is applied. Immediately after this, the positive pulse-shape voltage which peak is small is applied. Then, the period in which no voltage is applied is provided. The foregoing pulse train is repeatedly applied to the work 2.

Also in the case where the pulse-shape voltage has the waveform as shown in Fig. 8, the positive ions are accelerated and implanted into the work 2 similarly to the examples shown in Figs. 5 to 7 when the negative pulse-shape voltage is applied. As a result, ions are implanted into the work 2. When the positive ions are implanted into the work 2 at this time, positive charges are accumulated in the work 2. When the positive pulse-shape voltage is applied, electrons are implanted into the work 2. Thus, the electric charges accumulated in the work 2 can be neutralized.

In the example shown in Fig. 8, the absolute value of the pulse peak of the positive pulse-shape voltage is made to be smaller than the absolute value of the pulse peak of the negative pulse-shape voltage. The positive charges accumulated in the work 2 can satisfactorily be neutralized by the smaller absolute value of the positive pulse. When the period in which no voltage is applied is provided between the pulses, positive charges accumulated in the work 2 can be removed in the foregoing period. Therefore, the positive pulse-shape voltage for neutralizing the electric charges accumulated in the work 2 can be reduced.

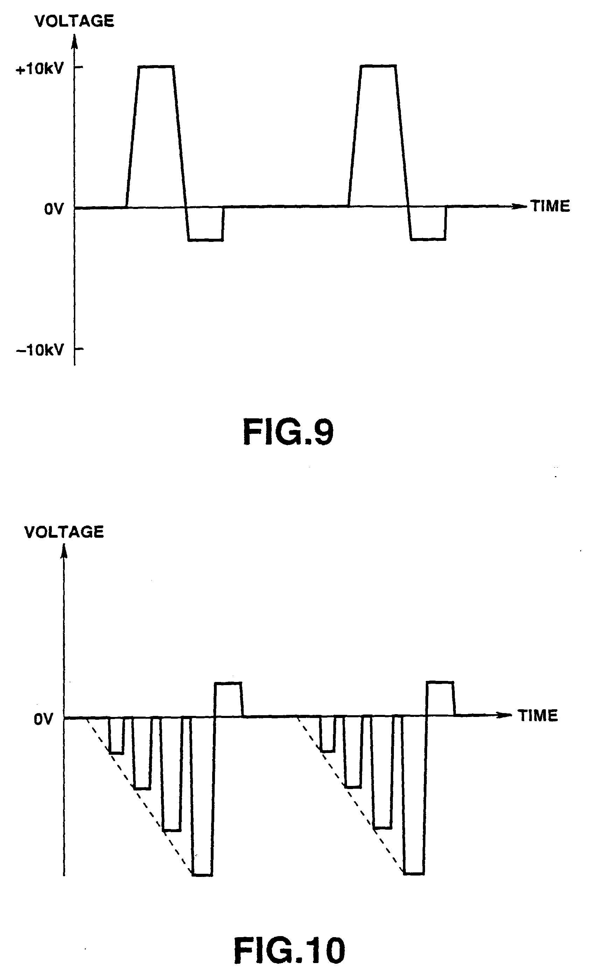

In an example shown in Fig. 9, the order of the positive pulse-shape voltage and the negative pulse-shape voltage shown in Fig. 8 is inverted. That is, the example shown in Fig. 9 is structured such that the positive pulse-shape voltage is first applied. Immediately after this, the negative pulse-shape voltage which peak is small is applied. Then, the period in which no voltage is applied is provided. The pulse train of the foregoing type is repeatedly applied to the work 2.

Also in the case where the pulse-shape voltage has the waveform as shown in Fig. 9, positive ions are accelerated and implanted into the work 2 similarly to the examples shown in Figs. 5 to 8 when the negative pulse-shape voltage is applied. As a result, ions are implanted into the work 2. Since the positive ions are implanted into the work 2, positive charges are accumulated in the work 2. When the positive pulse-shape voltage is applied, electrons are implanted into the work 2. Thus, the positive charges accumulated in the work 2 can be neutralized.

In the example shown in Fig. 9, the absolute value of the pulse peak of the positive pulse-shape voltage is made to be larger than the absolute value of the pulse peak of the negative pulse-shape voltage. The neutralization of the electric charges accumulated in the work 2 can be performed by enlarging the positive pulse. In the foregoing case, when positive pulse-shape voltage is applied, electrons in a quantity for neutralizing the positive charges accumulated in the work 2 can be implanted into the work 2. Therefore, the foregoing example attains an effect of the surface modification to be obtained owing to the irradiation with electrons.

In an example shown in Fig. 10, a plurality of negative pulse-shape voltages are initially applied. The waveform is formed by continuing pulses in which the negative voltages are gradually enlarged. Thus, the waveform is composed of pulse train having a moderate negative inclination as indicated with a dashed line. In the example shown in Fig. 10, the foregoing negative pulse-shape voltages are applied. Immediately after this, the positive pulse-shape voltage is applied. Then, a period in which no voltage is applied is provided. The foregoing pulse train is repeatedly applied to the work 2.

When the pulse-shape voltage has the waveform as shown in Fig. 10, positive ions are accelerated and implanted into the work 2 after the plurality of the negative pulse-shape voltages are applied. As a result, ions are implanted into the work 2. Since positive ions are implanted into the work 2, positive charges are accumulated in the work 2. When the positive pulse-shape voltage is applied, electrons are implanted into the work 2. Thus, positive charges accumulated in the work 2 can be neutralized.

In the foregoing example, the negative pulse-shape voltage which is the bias voltage for accelerating and implanting positive ions into the work 2 is formed by combining a plurality of pulses. The implantation profile when ions are implanted into the work 2 can furthermore finely be controlled.

In the examples shown in Figs. 5 to 10, the period in which no voltage is applied is provided between the pulses. In the period in which no voltage is applied, ions moved to the work 2 and having the initial energy are deposited on the work 2. Therefore, in the period in which no voltage is applied, implantation of ions into the work 2 is not performed. In this case, a film is formed on the work 2. That is, in the examples shown in Figs. 5 to 10, both of an effect of the implantation of ions and an effect of film formation can be obtained.

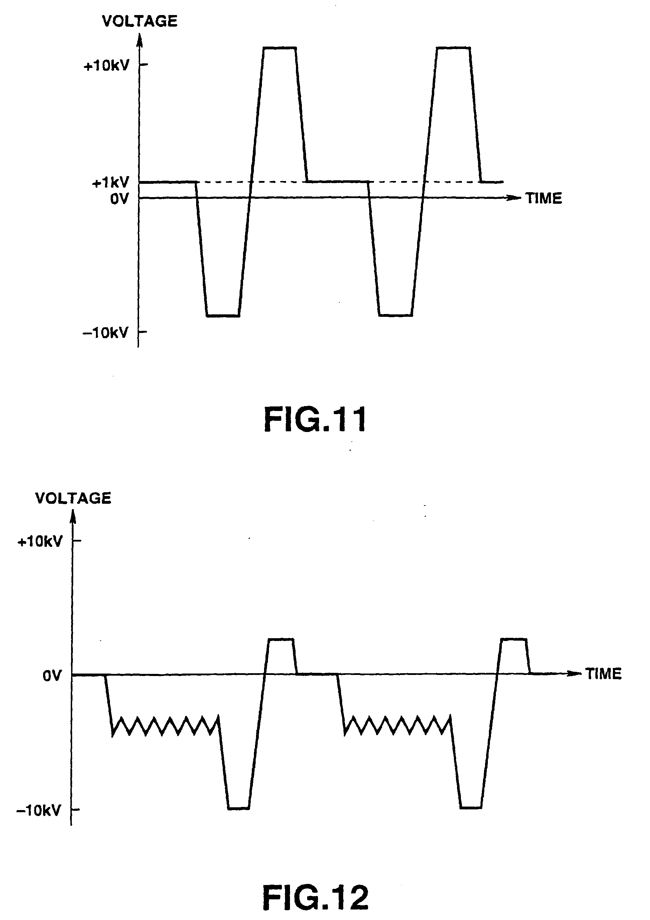

When film formation on the work 2 is not required, a DC voltage component is superposed on the pulse-shape voltage which is applied to the work 2. An example of a pulse-shape voltage on which the DC voltage component is superposed is shown in Fig. 11. When the positive DC voltage component is superposed on the pulse-shape voltage, film formation between the pulses can be prevented. Thus, only implantation of ions into the work 2 can be performed.

In the foregoing examples, ions are implanted when the negative voltage is applied to the work 2 according to conditions. Introduction of ions into the work 2 is sometimes inhibited when the negative voltage is applied to the work 2. Thus, a sputtering state is not realized.

That is, when a sufficiently high negative voltage is applied to the work 2, the energy of ions which are moved to the work 2 is enlarged sufficiently. Thus, ions are implanted into the work 2, causing a state in which ions are implanted to be realized. When the negative voltage which is applied to the work 2 is low, the energy of ions which are moved to the work 2 is too small to permit ions to be implanted into the work 2. Therefore, the sputtering state is realized.

Specifically, when the work 2 is made of plastic and ion source are made of carbon and the negative which is applied is about 10 kV, ions are sufficiently accelerated. Thus, a state in which ions are implanted is realized. When the negative voltage which is applied to the work 2 is about several hundreds of V, ions cannot sufficiently be accelerated. Thus, ions are not implanted into the work 2, causing the sputtering state to be realized.

When the work 2 is subjected to the surface modification, the foregoing sputtering state may positively be used. An example of the pulse-shape voltage which is used when the sputtering state is positively used is shown in Fig. 12.

When the sputtering state is positively used, a bias of about - several hundreds of V is applied as shown in Fig. 12 when the negative pulse-shape voltage is applied. Thus, the surface of the work 2 is sputtered. Then, a pulse of about - 10 kV is applied to implant ions into the work 2.

As described above, the voltage which is applied to the work 2 is adjusted so that implantation of ions into the work 2 and sputtering of the work 2 are permitted. That is, adjustment of the voltage which is applied to the work 2 enables the work 2 to be subjected to the surface modification which includes both of sputtering and ion implantation.

The foregoing apparatus 1 for surface modification is arranged to operate the mass separator 11 using pulses and control opening/closing of the shutter 7. Thus, ions which must be implanted into the work 2 can intermittently be supplied. The supply of ions which must be implanted into the work 2 may be performed in synchronization with the pulses of the bias voltage which is applied to the work 2. As a result, only implantation of ions into the work 2 may be performed. As an alternative to this, the surface modification is performed such that implantation of ions, film formation and sputtering are combined. Thus, the surface modification under required conditions can furthermore finely be controlled.

Examples of actual surface modification using the apparatus 1 for surface modification shown in Fig. 2 will now be described.

### First Example

In this example, the work 2 which must be processed was a plastic substrate obtained by molding amorphous polyolefine (APO) into a disc shape. The ions source which must be implanted into the work 2 were made of carbon. The ion generation source 10 was a filtered cathodic arc source manufactured by Commonwealth Scientific Corp.

Initially, the plastic substrate which must be subjected to the surface modification was joined to the holder 5 disposed in the vacuum chamber 3. To prevent excessive rise in the temperature of the plastic substrate after ions were implanted, cooling water was allowed to flow through the pipe for introducing cooling water disposed in the holder 5. The plastic substrate which must be subjected to the surface modification was joined to the holder 5, and then the inside portion of the vacuum chamber 3 was exhausted by the cryopump 4 to realize a high vacuum state. The degree of vacuum in the vacuum chamber 3, that is, the degree of vacuum (the background degree of vacuum) before ions were implanted into the vacuum chamber 3 was made to be about 10⁻⁷ Torr.

Then, carbon ions were generated by the ion generator 6, and then carbon ions were implanted into the vacuum chamber 3. An ion electric current caused from a flow of the carbon ions was about 10 A and the kinetic energy of these carbon ions was about 25 eV. Then, carbon ions were implanted into the vacuum chamber 3 so that plasma containing carbon ions was generated. The degree of vacuum in the vacuum chamber 3, that is, the degree of vacuum while ions were implanted, was about 10⁻⁵ Torr.

In a state in which the plastic substrate was placed in the plasma containing carbon ions, pulse-shape voltage was generated by the pulse power source 8. The pulse-shape voltage was, as the bias voltage, applied to the plastic substrate. As a result, carbon ions were implanted into the plastic substrate so that ions were implanted into the plastic substrate.

During ion implantation, generation of plasma sheath on the surface of the plastic which was the work 2 was observed.

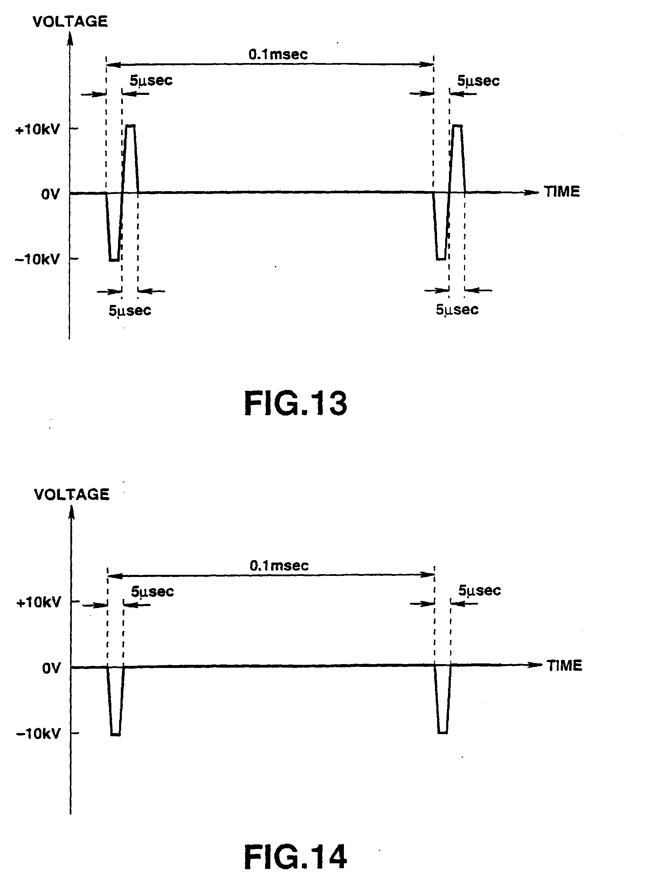

In this example, the waveform of the pulse-shape voltage which was applied to the plastic substrate was changed in order to compare with each other. Specifically, a first example was performed such that pulse-shape voltage in which positive and negative pulses alternately appeared as shown in Fig. 13 was applied to the plastic substrate. The pulse peak values of each of the positive and negative pulse-shape voltage were ± 10 kV. The width of each of the positive and negative pulses was 5 µsec. The interval between the pulses was 0.1 msec (10 kHz). A second example was performed as shown in Fig. 14 such that pulse-shape voltage composed of only negative pulses was applied to the plastic substrate. The pulse peak value of the pulse-shape voltage was - 10 kV. The pulse width was 5 µsec. The interval between the pulses was 0.1 msec (10 kHz).

The hardness of the surface of each of the plastic substrates into which ions were implanted under the foregoing conditions was measured. The measurement of the hardness of the surface was performed by nano-indentation hardness test using a thin-film hardness tester "MHA-400" manufactured by NEC.

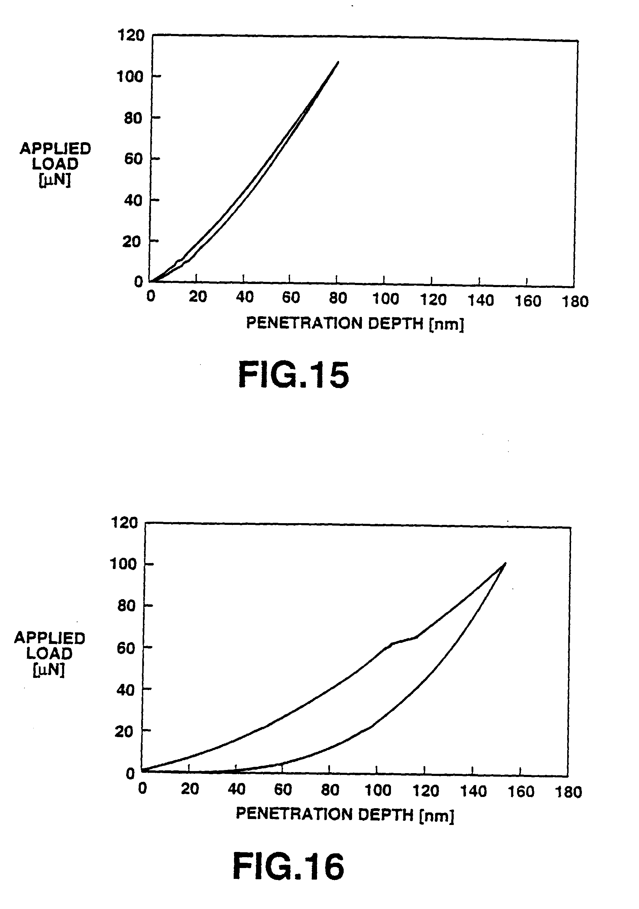

Result of measurement performed such that ions were implanted by applying the pulse-shape voltage shown in Fig. 13 is shown in Fig. 15. Result of measurement performed such that ions were implanted by applying the pulse-shape voltage shown in Fig. 14 is shown in Fig. 16. The axis of abscissa shown in Figs. 15 and 16 stands for the penetration depth of the indentator during the depression hardness test. The axis of ordinate stands for the magnitude of the applied load added to the indentator during the hardness test.

As can be understood from Figs. 15 and 16, a comparison was made with the case in which the pulse-shape voltage composed of only negative pulses was applied to the plastic substrate to implanted ions (in the case shown in Fig. 16). When pulse-shape voltage in which positive and negative pulses alternately appeared was applied to the plastic substrate (in the case shown in Fig. 15), amount of displacement realized after loading was reduced. Thus, the hardness of the surface was increased.

That is, when the pulse-shape voltage in which positive and negative pulses alternately appeared was applied to the plastic substrate to implant ions, a furthermore satisfactory effect of modifying the surface of the plastic substrate was obtained. The reason for this lies in that when ions were implanted by applying the pulse-shape voltage composed of only negative pulses to the plastic substrate, satisfactory implantation of ions was inhibited owing to charge-up. When the pulse-shape voltage in which positive and negative pulses alternately appeared was applied to the plastic substrate to implant ions, the charge-up state was prevented. Thus, implantation of ions was performed stably.

### Second Example

In this example, a plastic substrate obtained by molding amorphous polyolefine (APO) into a disc shape was coated with oil based ink. Thus, the work 2 was obtained. The thickness of the oil based ink which was applied to the surface of the plastic substrate was about 10 µm. The ion source which must be implanted into the work 2 were made of carbon. The ion generation source 10 was a filtered cathodic arc source manufactured by Commonwealth Scientific Corp.

Initially, the plastic substrate which was coated with the oil based ink was joined to the holder 5 disposed in the vacuum chamber 3. To prevent excessive rise in the temperature of the plastic substrate after ions were implanted, cooling water was allowed to flow through the pipe for introducing cooling water disposed in the holder 5. The plastic substrate coated with the oil based ink was joined to the holder 5, and then the inside portion of the vacuum chamber 3 was exhausted by the cryopump 4 to realize a high vacuum state. The degree of vacuum in the vacuum chamber 3, that is, the degree of vacuum (the background degree of vacuum) before ions were implanted into the vacuum chamber 3, was made to be about 2.1 × 10⁻⁷ Torr.

Then, carbon ions were generated by the ion generator 6, and then carbon ions were implanted into the vacuum chamber 3. An ion electric current caused from a flow of the carbon ions was about 10 A and the kinetic energy of these carbon ions was about 25 eV. Then, carbon ions were implanted into the vacuum chamber 3 so that plasma containing carbon ions was generated. The degree of vacuum in the vacuum chamber 3, that is, the degree of vacuum while ions were implanted, was about 5 × 10⁻⁵ Torr.

In a state in which the plastic substrate was placed in the plasma containing carbon ions, pulse-shape voltage in which positive and negative pulses alternately appeared was generated by the pulse power source 8. The pulse-shape voltage was, as the bias voltage, applied to the plastic substrate. As a result, carbon ions were implanted into the plastic substrate. The pulse peak values of each of the positive and negative pulse-shape voltage were ± 10 kV similarly to the first embodiment. The width of each of the positive and negative pulses was 5 µsec. The interval between the pulses was 0.1 msec (10 kHz). During ion implantation, occurrence of plasma sheath on the surface of the plastic substrate coated with the oil based ink was observed.

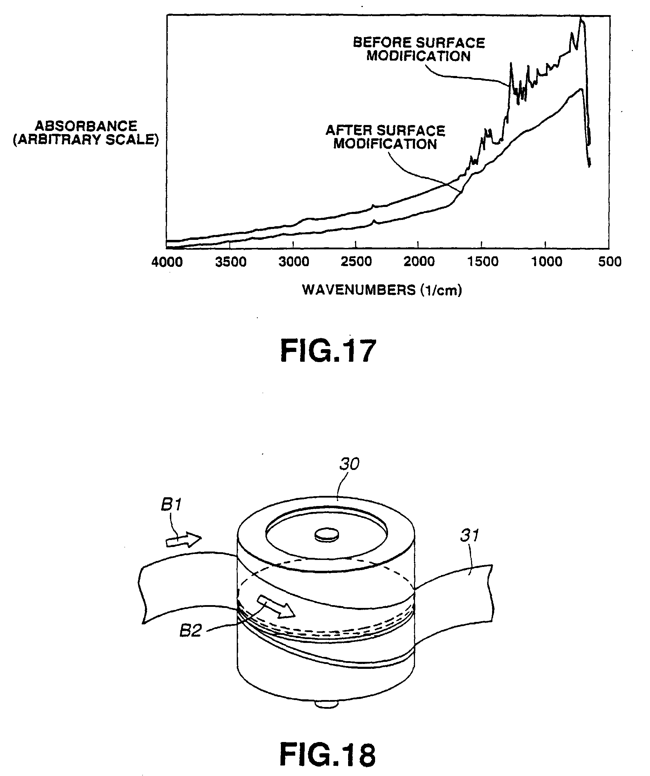

The infrared spectral characteristics of the plastic substrate coated with the oil based ink before and after the surface modification were measured by ATR (Attenuated Total Reflectance) method. The infrared spectral characteristics were measured by a microscope "FTIRAIM8000" for measuring ATR manufactured by Shimadzu. Results of the measurement of the infrared spectral characteristics are shown in Fig. 17. As shown in Fig. 17, the surface modification performed by implanting ions caused the surface characteristics of the plastic substrate coated with the oil based ink to be changed. As a result, the surface was modified owing to implantation of ions.

The plastic substrate coated with the oil based ink was subjected to a scratch test by using a surface evaluating apparatus manufactured by Heidon such that the state before and after the surface modification by implanting ions were evaluated. As a result, the surface was flawed owing to a load of 0.01 g before the surface modification. After the surface modification, the surface was not flawed when the load was smaller than 1 g.

After surface modification by implanting ions was performed, the plastic substrate coated with the oil based ink was immersed in solvent, such as acetone or ethanol so as to be cleaned with an ultrasonic cleaning machine for one hour. As a result, the oil based ink was hot dissolved. The reason for this lay in that the surface modification in which ions were implanted modified the oil based ink applied to the plastic substrate such that the oil based ink was made to be insoluble with respect to the solvent, such as acetone or ethanol.

In the foregoing example, the oil based ink was applied to the plastic substrate obtained by molding amorphous olefine (APO) into the disc shape so that the work 2 was obtained. The surface modification according to the present invention may be applied to a thin film formed on another substrate. For example, the substrate on which the thin film is formed may be a substrate made of polycarbonate (PC), polymethylmethacrylate (PMMA), polyethylene terephthalate (PET) or acrylic resin. As an alternative to this, the substrate may be a silicon substrate or a glass substrate.

According to the present invention, ions can be implanted into a variety of thin films. Specifically, ions can be implanted into a SiO₂ film or a SiNₓ film formed by a plasma CVD apparatus, a thin film made of ultraviolet curing resin applied by a spin-coating apparatus or a magnetic film formed by applying a material in which magnetic powder is mixed with a binder.

### Third Example

In this example, a rotative drum 30 structured as shown in Fig. 18 made of plastic was manufactured. The rotative drum 30 was employed as the work 2 which must be processed. The rotative drum 30 was arranged to be used to record/play a magnetic tape. When a magnetic tape is recorded/play by using the rotative drum 30, a magnetic tape 31 is wound around the rotative drum 30 as indicated with an arrow B1 shown in Fig. 18 so as to be moved. Moreover, the rotative drum 30 is rotated by a motor as indicated with an arrow B2 shown in Fig. 18. A magnetic head mounted on the rotative drum 30 records/play the magnetic tape 31.

Hitherto, the rotative drum for use to record/play the magnetic tape has been made of an aluminum alloy. The rotative drum made of the metal having a great weight causes the motor for rotating the rotative drum to bear a heavy load. If the rotative drum can be made of plastic, the weight of the rotative drum can considerably be reduced. Thus, the load which must be borne by the motor can significantly be reduced. Since plastic suffers from unsatisfactory hardness, the plastic rotative drum encounters excessive wear owing to sliding with the magnetic tape. As a result, the lifetime is excessively shortened. Therefore, the plastic rotative drum couldn't be put into practical use.

When the present invention was applied to subject the plastic rotative drum to the surface modification as described later, the hardness of the surface was considerably improved. As a result, the plastic rotative drum was enabled to be put into practical use.

In this example, the plastic rotative drum 30 structured as shown in Fig. 18 was manufactured. The rotative drum 30 was joined to the holder 5 disposed in the vacuum chamber 3. To prevent excessive rise in the temperature of the rotative drum 30 during implantation of ions, cooling water was allowed to flow through the pipe for introducing cooling water included in the holder 5. After the rotative drum 30 was joined to the holder 5, the inside portion of the vacuum chamber 3 was exhausted by the cryopump 4 so that a high vacuum state was realized. The degree of vacuum in the vacuum chamber 3, that is, the degree of vacuum (the background degree of vacuum) before ions were implanted into the vacuum chamber 3, was about 2.1 × 10⁻⁷ Torr.

Then, the ion generator 6 was operated to generate carbon, hydrogen and hydrocarbon ions. The generated ions were implanted into the vacuum chamber 3. The ion generation source 10 of the ion generator 6 was an RF plasma source. Methane gas in a quantity of 50 sccm was implanted so that carbon, hydrogen and hydrocarbon ions were generated from the methane gas.

The carbon, hydrogen and hydrocarbon ions were implanted into the vacuum chamber 3 so that plasma containing the foregoing ions was generated. The degree of vacuum in the vacuum chamber 3, that is, the degree of vacuum while ions were implanted was about 5 × 10⁻⁵ Torr.

In a state in which the rotative drum 30 was placed in the plasma containing the carbon, hydrogen and hydrocarbon ions, the pulse power source 8 generated pulse-shape voltage in which positive and negative pulses appeared alternately. The pulse-shape voltage was, as the bias voltage, applied to the rotative drum 30. As a result, ions were implanted into the rotative drum 30. The positive and negative pulse peak values of the pulse-shape voltage which was applied to the rotative drum 30 were ± 10 kV similarly to the first example. The pulse width was 5 µsec, and the interval between the pulses was 0.1 msec (10 kHz). Time for which ions were implanted was 5 minutes.

During ion implantation, occurrence of plasma sheath on the surface of the rotative drum 30 which was the work 2 was observed.

As described above, ions were implanted into the plastic rotative drum 30 so that the hardness of the surface of the rotative drum 30 was increased. To confirm the foregoing effect, a plastic sample made of the same material as that of the rotative drum 30 was manufactured. Then, the hardness of the surface of the sample before and after implantation of ions was measured by a thin-film hardness tester "MHA-400" manufactured by NEC. The hardness of the surface before implantation of ions was 0.5 GPa. On the other hand, the hardness of the surface after ions were implanted was 20 GPa. The foregoing hardness had satisfactory hardness to put the rotative drum into practical use. That is, the present invention is able to overcome the problem of the wear and put the plastic rotative drum into practical use.

In the present invention, ions were implanted by the plasma implantation method. Therefore, if the work 2 has a three-dimensional structure, ions can uniformly be implanted in a manner different from the ion beam implantation method. Hence it follows that ions can uniformly be implanted to the overall surface of the rotative drum if the work 2 is the rotative drum having the three-dimensional structure. Thus, the surface can be modified.

When the rotative drum is made of plastic, the insulating characteristic of the surface sometimes raises a problem in that the magnetic tape adheres to the rotative drum. In the foregoing case, implantation of ions is performed such that also ions of metal, such as Ti, are implanted. Thus, conductivity can be imparted to the surface of the rotative drum. As a result, the problem of adhesion of the magnetic tape can be overcome.

Specifically, when methane gas is implanted into the ion generation source 10 to generate ions, also organic metal, such as Ti (CH₃)₂Cl₂, tetramethylamino titanate, tetrakisdimethylamino titanium (TDMAT) or tetrakisdiethylamino titanium (TDEAT) is implanted together with the methane gas. Also titanium ions are supplied into the plasma. Thus, the surface of the rotative drum can be made to be a titanium surface. As a result, the problem of adhesion of the magnetic tape can be overcome.

When a thin conductive film is formed on the surface of the rotative drum, the problem of the adhesion of the magnetic tape can be overcome. When the thin conductive film is just formed on the plastic element, adhesiveness is unsatisfactory to realize satisfactory durability. Therefore, it is preferable that the problem of the adhesion of the magnetic tape is overcome by also implanting ions of metal, such as Ti, when ions are implanted to impart conductivity to the surface of the rotative drum.

When a thin film is afterwards formed on the rotative drum, the machining accuracy of the surface is sometimes changed according to conditions under which the thin film is formed. Ions are implanted along the surface of the rotative drum. Therefore, change in the machining accuracy of the surface of the rotative drum can be prevented. If the surface roughness realized after a machining process is 0.8S, also the surface roughness of about 0.8S is maintained after ions are implanted. Therefore, it is preferable that only the surface modification with which ions are implanted is performed from a viewpoint for maintaining the accuracy of machining of the surface.

The rotative drum subjected to the surface modification (including implantation of titanium ions) using implantation of ions was mounted on a movement test apparatus so that a movement test was performed. The movement test apparatus was structured such that the rotative drum was rotated and the magnetic tape was moved to perform the movement test similarly to the process for performing recording/play of a magnetic tape by the helical scan method. Winding and rewinding of the magnetic tape were automatically repeated so as to continuously move the magnetic tape.

The rotative drum subjected to the surface modification using implantation of ions was mounted on the movement test apparatus to perform the movement test for 1000 hours. As a result, wear of the rotative drum and adhesion of the magnetic tape were prevented. Therefore, a fact was confirmed that the lifetime was 1000 hours or longer. As can be understood from the result of the movement test, the surface modification according to the present invention is able to overcome the problem of wear of the plastic rotative drum and adhesion of the magnetic tape. As a result, the plastic rotative drum can be put into practical use.

When the rotative drum which has been made of an aluminum alloy is made of plastic, the weight of the rotative drum can be reduced. Thus, the load which must be borne by the motor for rotating the rotative drum can be reduced to about 1/10. Since the load which must be borne by the motor can be reduced, electric power required to operate a helical scan magnetic recording/reproducing apparatus can considerably be reduced. As a result, time for which the operation is permitted by, for example, a battery, can considerably be elongated. Since electric power can be reduced, a satisfactory effect can be obtained for the global environment.

### Fourth Example

In this example, the work 2 was a plastic disc substrate employed as a disc recording medium, such as an optical disc, a magneto-optical disc or a magnetic disc. The insulator which must be subjected to the surface modification was a base member for supporting a recording layer of the recording medium. The ion source which must be implanted into the work 2 were made of carbon. The ion generation source 10 was a filtered cathodic arc source manufactured by Commonwealth Scientific Corp.

Initially, the disc substrate which must be subjected to the surface modification was joined to the holder 5 disposed in the vacuum chamber 3. To prevent excessive rise in the temperature of the disc substrate during implantation of ions, cooling water was allowed to flow through the pipe for introducing cooling water included in the holder 5. The disc substrate which must be subjected to the surface modification was joined to the holder 5. Then, the inside portion of the vacuum chamber 3 was exhausted by the cryopump 4 so that a high vacuum state was realized. The degree of vacuum in the vacuum chamber 3, that is, the degree of vacuum (the background degree of vacuum) realized before ions were implanted into the vacuum chamber 3, was made to be about 10⁻⁷ Torr.

Then, the ion generator 6 was operated so that carbon ions were generated. Then, generated carbon ions were implanted into the vacuum chamber 3. An ion electric current caused from a flow of the carbon ions was about 10 A and the kinetic energy of these carbon ions was about 25 eV. Then, these carbon ions were implanted into the vacuum chamber 3 so that plasma containing carbon ions was generated. The degree of vacuum in the vacuum chamber 3, that is, the degree of vacuum while ions were implanted, was about 10⁻⁵ Torr.

In a state in which the disc substrate was placed in the plasma containing carbon ions, the pulse power source 8 was operated to generate pulse-shape voltage containing positive pulse-shape voltage and negative pulse-shape voltage. The pulse-shape voltage was, as the bias voltage, applied to the disc substrate. As a result, carbon ions were implanted into the disc substrate.

During ion implantation, occurrence of plasma sheath on the surface of the disc substrate which must be subjected to the surface modification was observed.

The permeability of water and oxygen of the disc substrate before and after the surface modification of the disc substrate using implantation of ions were measured.

As a result, the permeability of water before the surface modification using implantation of ions was 10 g/m²·24h. The permeability of oxygen was 100 cm³/m²·24h·atm. After the surface modification using implantation of ions was performed, the permeability of water was 0.007 g/m²·24h. The permeability of oxygen was 0.3 cm³/m²·24h·atm. Thus, the surface modification using implantation of ions enabled the permeability of water and oxygen to considerably be reduced.

Hitherto, the plastic disc substrate suffers from the problem in that the disc substrate absorbs water and oxygen in the atmosphere and, therefore, the disc substrate is deformed. The present invention in which ions are implanted is able to considerably reduce the permeability of water and oxygen. Thus, the fact that the disc substrate absorbs water and oxygen in the atmosphere can be prevented. That is, according to the present invention in which ions are implanted into the plastic disc substrate, deformation of the disc substrate caused from the fact that the disc substrate absorbs water and oxygen in the atmosphere can be prevented.

### Fifth Example

In this example, the work 2 which must be subjected to the surface modification was a magnetic disc incorporating a disc substrate on which a magnetic layer was formed. Ions were implanted into a protective film formed on the magnetic layer. That is, the insulator which must be subjected to the surface modification was the recording medium incorporating a base member on which a recording layer was formed. The ion source which were implanted into the work 2 were made of carbon. The ion generation source 10 was a filtered cathodic arc source manufactured by Commonwealth Scientific Corp.

In this example, initially, magnetic powder was mixed with a binder so as to be applied to the surface of a plastic disc substrate. Thus, a magnetic disc incorporating a disc substrate on which a magnetic layer was formed was manufactured.

The magnetic disc was joined to the holder 5 disposed in the vacuum chamber 3. To prevent excessive rise in the temperature of the magnetic disc during implantation of ions, cooling water was allowed to flow through the pipe for introducing cooling water included in the holder 5. The magnetic disc which must be subjected to the surface modification was joined to the holder 5. Then, the inside portion of the vacuum chamber 3 was exhausted by the cryopump 4 so that a high vacuum state was realized. The degree of vacuum, in the vacuum chamber 3, that is, the degree of vacuum (the background degree of vacuum) realized before ions were implanted into the vacuum chamber 3 was about 10⁻⁷ Torr.

Then, the ion generator 6 was operated to generate carbon ions. Then, carbon ions were implanted into the vacuum chamber 3. An ion electric current caused from a flow of carbon ions was about 10 A. The kinetic energy of these carbon ions was about 25 eV. Then, carbon ions were implanted into the vacuum chamber 3 so that plasma containing carbon ions was generated. The degree of vacuum in the vacuum chamber 3, that is, the degree of vacuum while ions were implanted, was about 10⁻⁵ Torr.

In a state in which the magnetic disc was placed in the plasma containing carbon ions, the pulse power source 8 was operated to generate pulse-shape voltage including positive pulse-shape voltage and negative pulse-shape voltage. The pulse-shape voltage was, as the bias voltage, applied to the magnetic disc. Thus, carbon ions were implanted into the substrate so that ions were implanted into the magnetic layer of the magnetic disc.

During ion implantation, occurrence of plasma sheath on the surface of the magnetic disc which must be subjected to the surface modification was observed.

Since ions were implanted into the magnetic layer of the magnetic disc, the hardness of the surface of the magnetic layer was increased. Thus, the density and reliability of the magnetic disc were improved.

When ions are implanted by the method according to the present invention, control of the waveform of the pulse-shape voltage which is applied to the work 2 enables the amount of ions which must be implanted into the work 2, the depth of implantation and the implantation profile to be controlled. When the surface modification of the magnetic disc is performed, it is preferable that the waveform of the pulse-shape voltage which is applied to the magnetic disc is controlled to implant ions into the portion adjacent to the surface of the magnetic layer in a maximum quantity. Thus, the portion adjacent to the surface of the magnetic layer can be modified and the hardness of the surface of the magnetic layer can significantly be increased.

When ions are implanted by the method according to the present invention, control of the waveform of the pulse-shape voltage which is applied to the work 2 enables ions to be implanted into the work 2 and also film formation to be permitted. Therefore, when the magnetic disc is subjected to the surface modification, the waveform of the pulse-shape voltage which is applied to the magnetic disc may be controlled to form the protective film for protecting the magnetic layer simultaneously with performing modification of the surface by implanting ions.

### Sixth Embodiment

In this example, the work 2 which must be subjected to the surface modification was a protective film for protecting a recording layer of a disc-shape recording medium, such as an optical disc, a magneto-optical disc or a magnetic disc. That is, a recording medium incorporating a base member on which a recording layer was formed and a protective film formed on the recording layer was subjected to the surface modification. Then, ions were implanted into the protective film formed on the recording layer. The ion source which must be implanted into the work 2 were made of carbon. The ion generation source 10 was a filtered cathodic arc source manufactured by Commonwealth Scientific Corp.

In this example, initially, a recording layer was formed on a disc substrate made of plastic. Then, a spin-coating apparatus was operated to form a protective film made of ultraviolet curing resin on the recording layer. Thus, a disc-shape recording medium was manufactured which incorporated a disc substrate on which the recording layer and the protective film were laminated.

The disc-shape recording medium was joined to the holder 5 disposed in the vacuum chamber 3. To prevent excessive rise in the temperature of the disc-shape recording medium while ions were implanted, cooling water was allowed to flow through the pipe for introducing cooling water included in the holder 5. Then, the disc-shape recording medium which must be subjected to the surface modification was joined to the holder 5. Then, the inside portion of the vacuum chamber 3 was exhausted by the cryopump 4 so that a high vacuum state was realized. The degree of vacuum in the vacuum chamber 3, that is, the degree of vacuum (the background degree of vacuum) before ions were implanted into the vacuum chamber 3, was about 10⁻⁷ Torr.

Then, the ion generator 6 was operated to generate carbon ions. Then, carbon ions were implanted into the vacuum chamber 3. An ion electric current caused from a flow of carbon ions was about 10 A. The kinetic energy of these carbon ions was about 25 eV. Then, carbon ions were implanted into the vacuum chamber 3 so that plasma containing carbon ions was generated. The degree of vacuum in the vacuum chamber 3, that is, the degree of vacuum while ions were implanted was, about 10⁻⁵ Torr.

In a state in which the disc-shape recording medium was placed in the plasma containing carbon ions, the pulse power source 8 was operated to generate pulse-shape voltage containing positive pulse-shape voltage and negative pulse-shape voltage. The pulse-shape voltage was, as the bias voltage, applied to the disc-shape recording medium. Thus, carbon ions were implanted into the disc-shape recording medium so that ions were implanted into the protective film of the disc-shape recording medium.

During ion implantation, occurrence of plasma sheath on the surface of the disc-shape recording medium was observed.

Since ions were implanted into the protective film of the disc-shape recording medium, the hardness of the surface of the protective film was increased. Thus, the durability and reliability of the disc-shape recording medium were improved. For example, a disc-shape recording medium which has been implanted into a cartridge for the purpose of preventing a flaw can be used without a necessity of introducing the disc-shape recording medium into the cartridge.

When ions are implanted by the method according to the present invention, control of the waveform of the pulse-shape voltage which must be applied to the work 2 enables the amount of ions which must be implanted into the work 2, the depth of implantation and the implantation profile to be controlled. Therefore, it is preferable that the disc-shape recording medium is subjected to the surface modification such that the waveform of the pulse-shape voltage which is applied to the disc-shape recording medium is controlled to cause ions to be implanted into a portion adjacent to the surface of the protective film in a maximum quantity. Thus, a portion adjacent to the surface of the protective film can be modified and the hardness of the surface of the protective film can significantly be increased.

### Seventh Embodiment

In this example, a panel substrate of a liquid crystal panel in which liquid crystal was enclosed was manufactured by using plastic. The work 2 which must be subjected to the surface modification was the foregoing panel substrate. The ion source which must be implanted into the work 2 were made of carbon. The ion generation source 10 was a filtered cathodic arc source manufactured by Commonwealth Scientific Corp.

Initially, the panel substrate which must be subjected to the surface modification was joined to the holder 5 disposed in the vacuum chamber 3. To prevent excessive rise in the temperature of the panel substrate while ions were implanted, cooling water was allowed to flow through the pipe for introducing cooling water disposed in the holder 5. Then, the panel substrate which must be subjected to the surface modification was joined to the holder 5. Then, the inside portion of the vacuum chamber 3 was exhausted by the cryopump 4 so that a high vacuum state was realized. The degree of vacuum in the vacuum chamber 3, that is, the degree of vacuum (the background degree of vacuum) before ions were implanted into the vacuum chamber 3, was about 10⁻⁷ Torr.

Then, the ion generator 6 was operated so that carbon ions were generated. Then, carbon ions were implanted into the vacuum chamber 3. An ion electric current caused from a flow of carbon ions was about 10 A. The kinetic energy of these carbon ions was about 25 eV. Then, carbon ions were implanted into the vacuum chamber 3 so that plasma containing carbon ions was generated. The degree of vacuum in the vacuum chamber 3, that is, the degree of vacuum while ions were implanted, was about 10⁻⁵ Torr.

In a state in which the panel substrate was disposed in the plasma containing carbon ions, the pulse power source 8 was operated to generate pulse-shape voltage containing positive pulse-shape voltage and negative pulse-shape voltage. The pulse-shape voltage was, as the bias voltage, applied to the panel substrate. Thus, carbon ions were implanted into the panel substrate so that ions were implanted into the panel substrate.

During ion implantation, occurrence of plasma sheath on the surface of the panel substrate which must be subjected to the surface modification was observed.

Then, the permeability water and oxygen of the panel substrate before and after the surface modification of the panel substrate using implantation of ions were measured. As a result, the permeability of water before the surface modification using implantation of ions was 10 g/m²·24h. The permeability of oxygen was 100 cm³/m²·24h·atm. After the surface modification using implantation of ions was performed, the permeability of water was 0.007 g/m²·24h. The permeability of oxygen was 0.3 cm³/m²·24h·atm. Thus, the surface modification using implantation of ions enabled the permeability of water and oxygen to considerably be reduced. Thus, the permeability of water and oxygen of the plastic panel substrate were made to be similar to those of a panel substrate made of glass.

Hitherto, the panel substrate of the liquid crystal panel into which liquid crystal is enclosed has been made of glass. If the panel substrate can be made of plastic, the weight and cost of the liquid crystal panel can satisfactorily be reduced. However, plastic suffering from poor gastightness inhibits employment of the plastic panel substrate for enclosing liquid crystal.

If ions are implanted by the method according to the present invention, the water vapor permeability and oxygen permeability of the plastic panel substrate can be improved to be similar to those of the glass. Therefore, implantation of ions by the method according to the present invention enables a plastic panel substrate of a liquid crystal panel for enclosing liquid crystal to be manufactured.

### Eighth Example

In this example, printing of a plastic substrate was performed on the work 2 which must be subjected to the surface modification. That is, printed matter obtained by subjecting an insulator to a printing process was subjected to the surface modification. Then, ions were implanted into the surface of printing. The ion source which must be implanted into the work 2 were made of carbon. The ion generation source 10 was a filtered cathodic arc source manufactured by Commonwealth Scientific Corp.

In this example, initially, the plastic substrate subjected to the printing process was joined to the holder 5 disposed in the vacuum chamber 3. To prevent excessive rise in the temperature of the plastic substrate while ions were implanted, cooling water was allowed to flow through the pipe for introducing cooling water disposed in the holder 5. The plastic substrate subjected to the printing process was joined to the holder 5. Then, the inside portion of the vacuum chamber 3 was exhausted by the cryopump 4 so that a high vacuum state was realized. The degree of vacuum in the vacuum chamber 3, that is, the degree of vacuum (the background degree of vacuum) before ions were implanted into the vacuum chamber 3, was about 10⁻⁷ Torr.

Then, the ion generator 6 was operated to generate carbon ions. Then, carbon ions were implanted into the vacuum chamber 3. An ion electric current caused from a flow of carbon ions was about 10 A. The kinetic energy of these carbon ions was about 25 eV. Then, carbon ions were implanted into the vacuum chamber 3 so that plasma containing carbon ions was generated. The degree of vacuum in the vacuum chamber 3, that is, the degree of vacuum while ions were implanted, was about 10⁻⁵ Torr.

In a state in which the plastic substrate subjected to the printing process was placed in the plasma containing carbon ions, the pulse power source 8 was operated to generate pulse-shape voltage containing positive pulse-shape voltage and negative pulse-shape voltage. The pulse-shape voltage was, as the bias voltage, applied to the plastic substrate subjected to the printing process. As a result, carbon ions were implanted into the printed surface of the plastic substrate.

During ion implantation, occurrence of plasma sheath on the surface of the plastic substrate which must be subjected to the surface modification was observed.

The state before and after the surface modification of the plastic substrate subjected to the printing process was subjected to a scratch test using surface evaluation apparatus Heidon Type-22 manufactured by Shinto. As a result, the printed surface was flawed with a load of about 0.01 g before the surface modification. After the surface modification, the printed surface was free from any flaw with a load not heavier than 1 g.

After the surface modification using implantation of ions was performed, the plastic substrate was immersed in solvent, such as acetone or ethanol. Then, the plastic substrate was cleaned by an ultrasonic cleaning machine for one hour. Removal of printing was prevented. The reason for this lay in that the surface modification using implantation of ions enabled the ink printed on the plastic substrate to be modified to be insoluble with respect to the solvent, such as acetone or ethanol.

Since ions are implanted into the printed matter, printed ink can be modified and, therefore, removal of the printed matter can be prevented. Since ions are implanted by the plasma implantation method according to the present invention, ions can uniformly be implanted even if the work 2 has a three-dimensional structure in a manner different from the ion-beam implantation method. Therefore, ions can uniformly be implanted into the overall surface of the printed matter even if the printed matter has the three-dimensional structure. Therefore, removal of the printed matter from the overall printed surface can satisfactorily be prevented.

## Claims

1. A surface modification apparatus for implanting ions into an insulator, comprising:
means generating plasma containing said ions to be implanted into said insulator;
means applying pulse-shape voltage to said insulator;
means implanting ions into said insulator in said plasma atmosphere by applying positive and/or negative pulse-shape voltage to said insulator.

2. An apparatus for surface modification according to claim 1, wherein said apparatus has means controlling waveform of pulse-shape voltage applied to said insulator by said means applying pulse-shape voltage.

3. In a method for surface modification of an insulator by implanting ions; the improvement:
applying positive or negative pulse-shape voltage to an insulator in plasma containing ions to be implanted into said insulator;
implanting said ions into said insulator.

4. A method for surface modification according to claim 3, wherein there is a period being applied no voltage between the pulses when said pulse-shape voltage is applied to said insulator.

5. A method for surface modification according to claim 3, wherein said pulse-shape voltage is biased by DC voltage when said pulse-shape voltage are applied to said insulator.

6. A method for surface modification according to claim 3, wherein waveform of said pulse-shape voltage has 2 or more differential waveforms.

7. A method for surface modification according to claim 3, wherein at least one of the amount, depth of implantation and implantation profile of ions are controlled by controlling waveform of pulse-shape voltage applied to said insulator.

8. A method for surface modification according to claim 3, wherein said insulator is a rotative drum used in recording and/or reproducing magnetic tape in helical scanning formula.

9. A method for surface modification according to claim 3, wherein said insulator is a base member for supporting a recording layer of a recording medium.

10. A method for surface modification according to claim 3, wherein said insulator is a recording medium that consists of a base member on which a recording layer is formed.

11. A method for surface modification according to claim 3, wherein said insulator is a recording medium that on which recording layers are formed on a base member and a protective film is formed on said recording layer, and ions are implanted into the protective film on said recording media so that surface modification is performed.

12. A method for surface modification according to claim 3, wherein said insulator is a panel substrate for a liquid crystal panel to enclose liquid crystal.

13. A method for surface modification according to claim 3, wherein surface of said insulator is a substrate subjected to a printing process.
